# FASCICULE DE BREVET EUROPEEN

(11) **EP 4 564 031 B1**
(45) Date de publication et mention de la délivrance du brevet: **30.09.2026**
(21) Numéro de dépôt: 24214692.6
(22) Date de dépôt: 22.11.2024
(51) Int. Cl.: G01R 31/367, G01R 31/379, G01R 31/382, G01R 31/392, H01M 10/06, H01M 10/48, H05K 7/14

(54) **MÉTHODE ET DISPOSITIF POUR LA PRÉDICTION DE LA FIN DE VIE D'UNE BATTERIE AU PLOMB**
VERFAHREN UND VORRICHTUNG ZUR VORHERSAGE DES ENDES DER LEBENSDAUER EINER BLEIBATTERIE
METHOD AND APPARATUS FOR PREDICTING THE END OF LIFE OF A LEAD-ACID BATTERY

(30) Priorité: 29.11.2023 FR 2313249
(43) Date de publication de la demande: 04.06.2025
(73) Titulaire: Commissariat à l'Energie Atomique et aux Energies Alternatives, 75015 Paris (FR)
(72) Inventeur: DESEURE, Jonathan, 38054 GRENOBLE CEDEX 09 (FR); KIRCHEV, Angel, 38054 GRENOBLE CEDEX 09 (FR); KLEIN, Jean-Marie, 38054 GRENOBLE CEDEX 09 (FR)
(74) Mandataire: Santarelli

(56) Documents cités:
- EP-A1- 3 324 197
- CN-A- 109 765 496
- CN-A- 110 554 328
- CN-C- 100 483 146
- CN-U- 215 297 603
- JP-A- H07 183 049
- JP-A- H08 254 573

## Description

### Domaine de l'invention

La présente invention appartient au domaine de la gestion des batteries au plomb. Plus particulièrement, il est proposé une méthode et un dispositif pour détecter des prémices de fin de vie d'une batterie au plomb.

### Etat de la technique

Les batteries au plomb sont largement utilisées dans l'industrie, notamment dans l'équipement des véhicules ferroviaires et automobiles et dans les systèmes d'alimentation sans interruption des centres de données.

Les centres de données sont responsables du stockage, du traitement et de la transmission de grandes quantités de données. Ce sont des infrastructures essentielles dans le monde numérique actuel. Les serveurs des centres de données doivent rester opérationnels en permanence, il est donc impératif qu'ils soient alimentés par un système électrique fiable. C'est la raison pour laquelle les centres de données utilisent généralement des systèmes d'alimentation sans interruption (ASI, ou UPS pour « Uninterrupted Power Supply » en anglais).

Les batteries au plomb sont un élément essentiel des systèmes d'alimentation sans interruption pour un serveur de données. Les batteries stockent de l'énergie et, en cas de fluctuations ou de coupures du courant fourni par le réseau électrique, elles peuvent fournir une alimentation de secours pour garantir que le système reste opérationnel.

Les batteries au plomb sont largement utilisées en raison de leur faible coût, de leur longue durée de vie et de leur fiabilité. Elles sont également bien adaptées pour une utilisation dans des environnements à relativement haute température.

Les batteries au plomb nécessitent toutefois un entretien et une inspection de façon régulière pour garantir leur bon fonctionnement. Aussi, il est important de prévoir la fin de vie d'une batterie afin de la remplacer et ainsi éviter les pannes inhérentes et imprévisibles liées à ce type de batterie.

Il existe différentes méthodes de suivi de l'état de santé d'une batterie au plomb. Par exemple, il est connu du surveiller la tension, la résistance interne, la capacité ou la température de la batterie (une tension basse, une résistance interne élevée, une perte de capacité ou une température élevée peut indiquer une batterie défectueuse). Il est également connu de surveiller la présence de corrosion dans la batterie, ce qui peut entrainer une défaillance prématurée.

La charge d'une batterie au plomb se fait généralement en deux phases successives. Pendant une première phase dite « CC » (acronyme anglais pour « Constant Current », « courant constant » en français) le courant qui circule dans la batterie est maintenue à une valeur sensiblement constante. Pendant cette première phase, la tension aux bornes de la batterie augmente au fur et à mesure que la batterie se recharge. Pendant une deuxième phase dite « CV » (acronyme anglais pour « Constant Voltage », « tension constante » en français) la tension aux bornes de la batterie est maintenue à une valeur sensiblement constante. Pendant cette deuxième phase, le courant suit généralement une fonction décroissante du temps. Le courant qui circule dans la batterie pendant la phase CV est souvent dénommé « courant de floating ». II permet d'empêcher le déchargement naturel de la batterie au plomb.

JP H08 254573 A divulgue une méthode pour la prédiction de la fin de vie d'une batterie au plomb de l'état de l'art.

Dans le domaine des batteries au lithium, la demande de brevet EP 3324197 A1 décrit une méthode pour déterminer l'état de santé d'une cellule de la batterie en fonction d'un rapport entre une variation de charge et une différence de courant mesurées entre deux instants d'une phase CV (phase de recharge à tension constante) d'un cycle CC-CV (cycle de charge comportant une phase de recharge à courant constant suivi d'une phase de recharge à tension constante).

La fiabilité des méthodes actuelles de suivi de l'état de santé d'une batterie au plomb n'est pas toujours pleinement satisfaisante. En particulier, ces méthodes ne permettent généralement pas de prédire avec suffisamment de précision et de fiabilité la fin de vie d'une batterie au plomb.

### Exposé de l'invention

La présente invention a pour objectif de remédier à tout ou partie des inconvénients de l'art antérieur, notamment ceux exposés ci-avant.

A cet effet, et selon un premier aspect, il est proposé par la présente invention, une méthode pour la prédiction de la fin de vie d'une batterie au plomb. La méthode comporte, pour chaque segment d'une pluralité de segments d'une phase de « tension constante » (phase CV) d'un cycle de charge de la batterie :
- une collecte d'une pluralité de mesures de courant circulant dans la batterie pendant ledit segment, ladite pluralité de mesures formant un signal de « courant de floating » pour ledit segment,
- une décomposition en modes empiriques du signal de courant de floating afin d'en obtenir une représentation sous la forme d'une somme d'un signal résiduel et d'une ou plusieurs composantes intrinsèques,
- un calcul d'une énergie intrinsèque pour chaque composante intrinsèque,
- un calcul d'une énergie intrinsèque totale en fonction des énergies intrinsèques des différentes composantes intrinsèques,
- une évaluation d'un critère de détection de fin vie pour la batterie en fonction de l'énergie intrinsèque totale.

La présente invention trouve des applications particulièrement avantageuses, bien que nullement limitatives, dans la surveillance d'une batterie au plomb d'un système d'alimentation sans interruption d'un serveur de données, ou dans la surveillance d'une batterie au plomb d'un véhicule automobile. Rien n'empêcherait toutefois d'appliquer la présente invention dans d'autres domaines.

La méthode proposée se distingue nettement des méthodes conventionnelles en ce qu'elle se base sur l'analyse du courant de floating pendant la phase CV d'un cycle de charge de la batterie. Rien ne suggère au premier abord que ce signal renferme des informations pertinentes pour le suivi de l'état de santé de la batterie.

La décomposition en modes empiriques est particulièrement bien adaptée à l'analyse de ce signal. Cette décomposition présente en outre l'avantage d'être relativement rapide et peu gourmande en termes de capacité de calcul.

Le suivi de l'énergie intrinsèque totale de la batterie permet de détecter les prémices de fin de vie de la batterie. Cela permet ainsi de prévoir le remplacement de la batterie de façon anticipée et efficace afin d'éviter une panne.

Dans des modes particuliers de mise en œuvre, l'évaluation du critère de détection de fin de vie comprend une comparaison de l'énergie intrinsèque totale du segment avec un seuil d'énergie prédéterminé.

Dans des modes particuliers de mise en œuvre, l'évaluation du critère de détection de fin de vie comprend une vérification si l'énergie intrinsèque totale est inférieure ou égale au seuil d'énergie pour un nombre prédéterminé de segments consécutifs.

Dans des modes particuliers de mise en œuvre, l'évaluation du critère de détection de fin de vie comprend un calcul d'une énergie intrinsèque totale moyenne pour le segment et des segments précédents, et une comparaison d'une distance entre l'énergie intrinsèque totale du segment et l'énergie intrinsèque totale moyenne avec un seuil de distance prédéterminé.

Dans des modes particuliers de mise en œuvre, l'énergie intrinsèque totale moyenne est calculée en prenant en compte l'énergie intrinsèque totale du segment et les énergies intrinsèques totales de tous les segments précédents.

Dans des modes particuliers de mise en œuvre, l'énergie intrinsèque totale moyenne est calculée en prenant en compte l'énergie intrinsèque totale du segment et les énergies intrinsèques totales d'un sous-ensemble des segments précédents.

Ces différentes conditions peuvent être utilisées de façon individuelle ou en combinaison pour détecter la fin de vie de la batterie.

Dans des modes particuliers de mise en œuvre, la méthode comporte en outre, pour chaque segment de la pluralité de segments, une estimation d'une fiabilité statistique du segment, en fonction des composantes intrinsèques du signal de courant de floating du segment. Le segment est alors filtré si celui-ci est jugé non fiable.

Dans des modes particuliers de mise en œuvre, la fiabilité statistique du segment est estimée en fonction d'une entropie calculée pour une somme des composantes intrinsèques du signal de courant de floating du segment.

Dans des modes particuliers de mise en œuvre, pour chaque segment de la pluralité de segments, la fiabilité statistique d'un segment est estimée en comparant l'énergie intrinsèque totale du segment avec un seuil de fiabilité prédéterminé, ou avec les énergies intrinsèques totales calculées pour tout ou partie des segments précédents.

Cette étape de filtrage permet d'écarter les segments présentant des valeurs aberrantes (segments jugés non fiables statistiquement).

Dans des modes particuliers de mise en œuvre, la batterie fait partie d'un système d'alimentation sans interruption pour un serveur de données.

Dans des modes particuliers de mise en œuvre, la batterie est une batterie d'un véhicule automobile.

Selon un deuxième aspect, il est proposé par la présente invention, un dispositif pour la prédiction de la fin de vie d'une batterie au plomb. Le dispositif comporte un système de gestion de batterie configuré pour fournir des mesures de courant circulant dans la batterie pendant une phase « tension constante » (phase CV) d'un cycle de charge de la batterie, et une unité de calcul connectée au système de gestion de batterie. L'unité de calcul est configurée pour mettre en œuvre une méthode selon l'un quelconque des mode de mise en œuvre précédemment décrits.

### Présentation des figures

L'invention sera mieux comprise à la lecture de la description suivante, donnée à titre d'exemple nullement limitatif, et faite en se référant aux figures 1 à 4 qui représentent :
[Fig. 1] une représentation schématique des principales étapes d'un exemple de mise en oeuvre de la méthode selon l'invention pour la prédiction de la fin de vie d'une batterie au plomb,
[Fig. 2] un graphique représentant l'évolution au cours du temps de la distance à la moyenne pour l'énergie intrinsèque totale pour trois batteries différentes,
[Fig. 3] un graphique illustrant la possibilité de prédire la fin de vie d'une batterie en suivant l'évolution au cours du temps de la distance à la moyenne de l'énergie intrinsèque totale de la batterie,
[Fig. 4] une représentation schématique d'un dispositif selon l'invention pour la prédiction de la fin de vie d'une batterie au plomb.

Dans ces figures, des références identiques d'une figure à une autre désignent des éléments identiques ou analogues. Pour des raisons de clarté, les éléments représentés ne sont pas nécessairement à une même échelle, sauf mention contraire.

### Description détaillée de l'invention

Une batterie au plomb est un accumulateur électrochimique dont les électrodes sont à base de plomb et l'électrolyte est un mélange d'eau et d'acide sulfurique. La batterie peut comporter une ou plusieurs cellules en série assemblées dans un même boîtier. Les électrodes sont généralement des plaques ou des grilles constituées d'un alliage de plomb durci (par exemple à l'aide d'étain, de cadmium et de strontium, à raison de quelques pour cent de l'alliage).

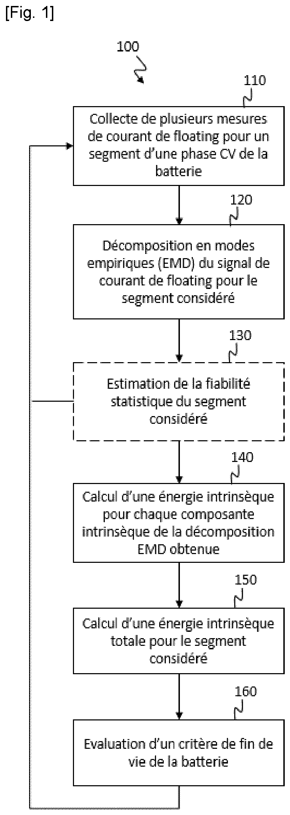

La figure 1 représente schématiquement les principales étapes d'un exemple de mise en oeuvre d'une méthode 100 selon l'invention pour la prédiction de la fin de vie d'une batterie au plomb. Il peut s'agir par exemple d'une batterie d'un véhicule automobile, ou d'une batterie d'un système d'alimentation sans interruption d'un serveur de données. Rien n'empêcherait toutefois d'appliquer la présente invention dans d'autres domaines.

Tel qu'illustré sur la figure 1, la méthode 100 comporte les étapes suivantes pour chaque segment d'une pluralité de segments d'une phase de « tension constante », ou phase CV, d'un cycle de charge de la batterie :
- une collecte 110 de plusieurs mesures de courant de floating de la batterie pendant le segment considéré,
- une décomposition en modes empiriques 120 (EMD pour « Empirical Mode Decomposition » en anglais) du signal de courant de floating formé par les mesures obtenues,
- un calcul 140 d'une énergie intrinsèque pour chaque composante intrinsèque obtenue par la décomposition EMD,
- un calcul 150 d'une énergie intrinsèque totale en fonction des énergies intrinsèques des différentes composantes intrinsèques,
- une évaluation 160 d'un critère de détection de fin vie pour la batterie en fonction de l'énergie intrinsèque totale.

Les différents segments correspondent à un découpage temporel de la phase CV considérée. Les mesures de courant de floating sont par exemple effectuées par un système de gestion de batterie (BMS pour « Battery Management System » en anglais) connecté à la batterie. Les mesures sont par exemple effectuées avec une fréquence d'acquisition comprise entre quinze et soixante secondes afin d'obtenir entre deux-cent et huit-cent mesures par segment (dans ce cas la durée d'un segment est alors comprise entre cinquante et huit-cent minutes). Rien n'empêcherait toutefois de faire les mesures avec une fréquence d'acquisition différente, et/ou avec un nombre différent de points par segment. Il est toutefois avantageux d'utiliser un nombre de mesures compris entre deux-cent et huit-cent mesures par segment (utiliser un plus grand nombre de mesures n'implique pas nécessairement une amélioration significative de la méthode, et cela entraine des temps de calcul relativement longs ; utiliser un nombre de mesures plus faible peut en revanche limiter les performances de la méthode). L'ensemble des mesures collectées pendant l'étape de collecte 110 forment un signal de courant de floating.

A l'étape 120, le signal de courant de floating est décomposé selon une décomposition en modes empiriques. Il est à noter que rien ne pouvait laisser présager que ce signal de courant de floating pouvait contenir des informations pertinentes sur l'état de santé de la cellule.

La décomposition en modes empiriques consiste à décomposer un signal sous la forme d'une somme de fonctions, de façon similaire à ce que fait la décomposition en série de Fourier ou la décomposition en ondelettes.

Une des particularités de la décomposition en modes empiriques est que la base de fonctions en lesquelles le signal est décomposé n'est pas connue a priori, mais elle est construite de façon adaptative en fonction des propriétés du signal.

La décomposition en modes empiriques correspond à la première partie de la transformée de Hilbert-Huang (HHT pour « Hilbert-Huang Transform » en anglais). La décomposition en modes empiriques consiste à décomposer un signal sous la forme d'une somme d'un signal résiduel et de fonctions de mode intrinsèque (IMF pour « Intrinsic Mode Function » en anglais). Dans la présente demande, ces fonctions de mode intrinsèque sont également appelées « composantes intrinsèques ».

Comme indiqué précédemment, les composantes intrinsèques ne sont pas définies analytiquement. Elles sont plutôt déterminées de façon adaptative en fonction des propriétés du signal.

Une composante intrinsèque (IMF) résultant d'une décomposition en modes empiriques (EMD) doit satisfaire aux exigences suivantes :
- le nombre d'extrema (c'est-à-dire la somme du nombre des maxima locaux et du nombre des minima locaux) et le nombre de passages par zéro de la composante intrinsèque doivent être égaux ou différer au maximum de un ;
- en tout point de la composante intrinsèque, la valeur moyenne de l'enveloppe définie par les maxima locaux et de l'enveloppe définie par les minima locaux est nulle.

Un signal s(t) décomposé par EMD peut alors s'écrire sous la forme : $s \left(t\right) = r \left(t\right) + {\sum }_{i = 1}^{N} {c}_{i} \left(t\right)$ Dans cette expression, r(t) correspond au signal résiduel, *N* est le nombre de composantes intrinsèques de la décomposition EMD, et *cᵢ*(*t*) est la composante intrinsèque d'indice *i*. Chaque composante intrinsèque *cᵢ* successive contient des oscillations de fréquence inférieure à celle de la précédente. Le signal résiduel correspond à une tendance générale du signal *s*(*t*)*.*

La décomposition en modes empiriques comporte une succession de processus de tamisage (« sifting process » en anglais). Le premier processus de tamisage prend en entrée le signal *s*(*t*) directement. Le processus de tamisage correspond à identifier tous les extrema locaux du signal d'entrée, et à relier les maxima locaux, respectivement les minima locaux, par une interpolation par splines cubiques, afin d'obtenir une enveloppe supérieure, respectivement une enveloppe inférieure. Une moyenne entre l'enveloppe supérieure et l'enveloppe inférieure peut alors être calculée et soustraite au signal d'entrée. Si le signal intermédiaire obtenu (soustraction du signal d'entrée avec la moyenne des enveloppes supérieure et inférieure) n'est pas une composante intrinsèque, le processus de tamisage est réitéré sur le signal intermédiaire (qui devient donc le signal d'entrée d'un nouveau processus de tamisage) jusqu'à obtenir une composante intrinsèque. Les processus de tamisage sont répétés jusqu'à obtenir la dernière composante intrinsèque, c'est-à-dire par exemple jusqu'à ce que le signal intermédiaire devienne monotone ou qu'il ne comporte plus qu'un seul extremum local. Le signal restant correspond alors au signal résiduel *r*(*t*).

Un critère d'arrêt peut être défini pour le processus de tamisage. Par exemple le critère d'arrêt est satisfait si l'écart-type entre les résultats de deux processus de tamisage successifs est inférieur ou égale à un seuil d'arrêt prédéterminé. Le seuil d'arrêt peut typiquement être compris entre 0.2 et 0.3.

Le document « The empirical mode decomposition and the Hilbert spectrum for non-linear and non-stationary time series analysis », Norden E. Huang et al., Proc. R. Soc. Lond. A (1998) 454, p. 903-995, décrit de façon détaillée la décomposition en modes empiriques, notamment dans ses sections 4 et 5.

Des algorithmes de décomposition en modes empiriques sont disponibles dans des bibliothèques de programmation, par exemple en langage MATLAB ou Python.

A l'étape 140 une énergie intrinsèque est calculée pour chaque composante intrinsèque obtenues par la décomposition EMD. L'énergie *Eᵢ* d'une composante intrinsèque *cᵢ* correspond par exemple à l'intégrale du carré de l'amplitude de la composante intrinsèque *cᵢ* sur la durée du segment considéré : ${E}_{i} = \int {\left|{c}_{i}\left(t\right)\right|}^{2} dt$

A l'étape 150, une énergie intrinsèque totale est calculée en fonction des énergies intrinsèques des différentes composantes intrinsèques de la décomposition EMD. L'énergie intrinsèque totale du segment considéré est par exemple égale à la somme des énergies des composantes intrinsèques obtenues par la décomposition EMD : $E = {\sum }_{i = 1}^{N} {E}_{i}$

Rien n'empêcherait toutefois, dans une variante, de calculer l'énergie intrinsèque totale en sommant les énergies d'un sous-ensemble des composantes intrinsèques obtenues par la décomposition EMD (par exemple en considérant seulement un nombre maximum prédéfini des premières composantes intrinsèques obtenues par la décomposition EMD).

A l'étape 160, un critère de détection de fin vie de la batterie est évalué en fonction de l'énergie intrinsèque totale du segment considéré.

Différentes conditions peuvent être évaluées, de façon individuelle ou en combinaison, pour détecter la fin de vie de la batterie à partir de la valeur d'énergie intrinsèque totale du segment considéré.

L'évaluation 160 du critère de détection de fin de vie peut notamment comprendre une comparaison de l'énergie intrinsèque totale du segment avec un seuil d'énergie prédéterminé. Par exemple, la fin de vie de la batterie (et donc la nécessité de remplacer la batterie) peut être détectée lorsque l'énergie intrinsèque totale devient inférieure ou égale au seuil d'énergie. Optionnellement, le critère de détection de fin de vie peut également comprendre une vérification si l'énergie intrinsèque totale est inférieure ou égale au seuil d'énergie pour un nombre prédéterminé de segments consécutifs. Par exemple, la fin de vie de la batterie est détectée si l'énergie intrinsèque totale reste inférieure ou égale au seuil d'énergie pour au moins cinq segments consécutifs.

Selon encore un autre exemple, et de façon particulièrement avantageuse, l'évaluation 160 du critère de détection de fin de vie peut comprendre un calcul d'une énergie intrinsèque totale moyenne pour le segment courant et des segments précédents, et une comparaison d'une distance entre l'énergie intrinsèque totale du segment courant et l'énergie intrinsèque totale moyenne avec un seuil de distance prédéterminé.

L'énergie intrinsèque totale moyenne, notée *E_{moy},* pour le segment et les segments précédents peut s'écrire sous la forme : ${E}_{moy} = \frac{1}{k} {\sum }_{j = 1}^{k} {E}_{j} = \frac{1}{k} {\sum }_{j = 1}^{k} {\sum }_{i = 1}^{{N}_{j}} {E}_{j , i}$ Dans cette expression, *k* correspond au numéro du segment courant (ce qui correspond également au nombre total des segments considérés par la méthode de prédiction) ; *Eⱼ* correspond à l'énergie intrinsèque totale du segment d'indice *j* (avec *j* variant entre 1 et *k) ; Nⱼ* est le nombre de composantes intrinsèques de la décomposition EMD du segment d'indice *j ; E_{j,i}* est l'énergie de la composante intrinsèque d'indice *i* (avec *i* variant entre 1 et *Nⱼ*)*.*

La distance Δ*Eₖ* entre l'énergie intrinsèque totale du segment courant d'indice *k* et l'énergie intrinsèque totale moyenne *E_{moy}* peut alors s'écrire : $Δ {E}_{k} = {\sum }_{i = 1}^{{N}_{k}} {E}_{k , i} - {E}_{moy} = {E}_{k} - {E}_{moy}$

Il est à noter qu'il serait aussi envisageable, pour le calcul de la moyenne, de considérer seulement un sous-ensemble des segments précédents au lieu de considérer l'ensemble de tous les segments précédents (autrement dit, il est envisageable d'utiliser une moyenne glissante sur un certain nombre de segments précédents, au lieu d'utiliser une moyenne sur tous les segments précédents).

Il est considéré que la valeur du seuil de distance est liée aux processus de corrosion de la batterie. Les processus de corrosion impliquent une multitude d'événements. Le nombre et les énergies de ces événements sont liés à la résistance interne de la batterie. Lorsque l'énergie décroit, cela signifie que la cellule arrive en fin de vie : la résistance augmente. Il est alors possible de fixer un seuil de distance à partir duquel on considère que la fin de vie de la batterie est détectée lorsque les deux conditions suivantes sont satisfaites :
- l'énergie intrinsèque totale *Eₖ* du segment courant est inférieure à l'énergie intrinsèque totale moyenne *E_{moy}* ; et
- la distance Δ*Eₖ* entre l'énergie intrinsèque totale *Eₖ* du segment courant et l'énergie intrinsèque totale moyenne *E_{moy}* devient supérieure au seuil en valeur absolue.

On peut aussi fixer un seuil de distance négatif et s'intéresser à la valeur relative de la distance (la distance Δ*Eₖ* est négative lorsque l'énergie intrinsèque totale *Eₖ* du segment courant est inférieure à l'énergie intrinsèque totale moyenne *E_{moy}*). Dans ce cas, la fin de vie de la batterie est détectée lorsque la distance Δ*Eₖ* entre l'énergie intrinsèque totale *Eₖ* du segment et l'énergie intrinsèque totale moyenne *E_{moy}* est inférieure au seuil.

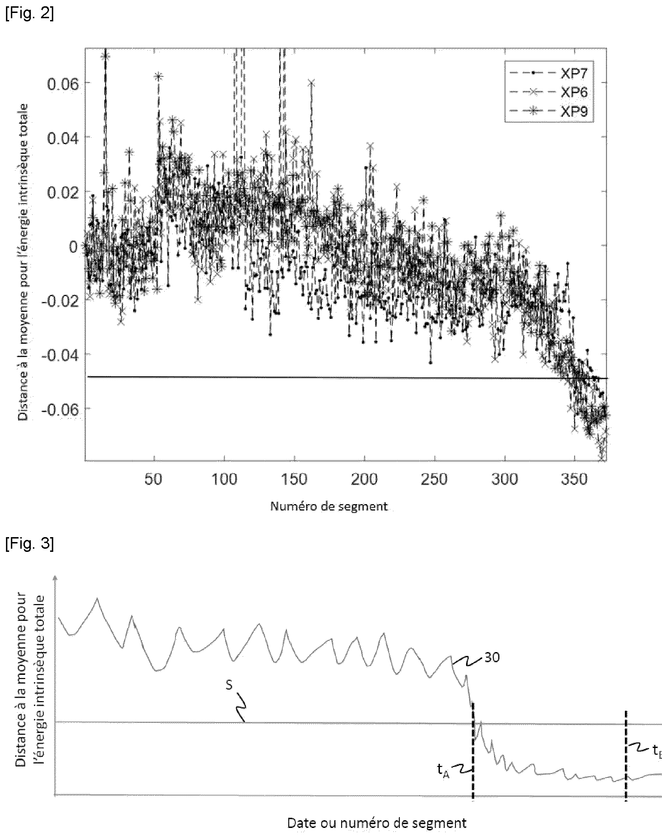

A titre d'exemple, le graphique de la figure 2 représente l'évolution au cours du temps de la distance à la moyenne pour l'énergie intrinsèque totale pour trois batteries différentes d'un système d'alimentation sans interruption pour un serveur de données. Sur ce graphique, l'axe des ordonnées représente la distance à la moyenne pour l'énergie intrinsèque totale. L'axe des abscisses représente le numéro de segment. Chaque segment a une durée de 800 minutes. Dans cet exemple, le seuil de distance est fixé à -0.045. Le seuil de distance peut notamment être déterminé en laboratoire de façon empirique, et il peut être spécifique à un type particulier de batterie. Dans l'exemple illustré sur la figure 2, les batteries subissent un vieillissement accéléré. On peut observer qu'au bout d'environ 350 segments (soit environ 195 jours), la différence Δ*Eₖ* entre l'énergie intrinsèque totale *Eₖ* du segment courant et l'énergie intrinsèque totale moyenne *E_{moy}* devient inférieure au seuil de distance. Dans l'exemple considéré et illustré à la figure 2, le critère de détection de fin vie d'une batterie est satisfait dès que cette condition reste satisfaite pendant au moins trois segments consécutifs.

La figure 3 illustre un deuxième exemple applicatif pour une batterie de voiture (batterie au plomb utilisée pour le démarrage de la voiture). La courbe 30 du graphique de la figure 3 illustre l'évolution au cours du temps de la distance à la moyenne de l'énergie intrinsèque totale de la batterie.

Là encore la méthode selon l'invention est particulièrement bien adaptée car hormis la période de démarrage très courte, la batterie est toujours maintenue à pleine charge par l'alternateur. L'ordinateur de bord de la voiture peut être configuré pour mesurer Δ*Eₖ* de façon continue et en temps réel, et pour afficher un message d'alerte lorsque Δ*Eₖ* satisfait le critère de détection de fin de vie de la batterie. Le message d'alerte indique qu'un changement de batterie est à prévoir. Cela permet d'éviter les pannes inhérentes et imprévisibles liées à ce genre de batterie.

La valeur du seuil utilisé pour l'évaluation 160 du critère de détection de fin de vie de la batterie peut être déterminée en laboratoire en réalisant des essais sur la batterie. La valeur du seuil peut notamment être déterminée pour laisser une période prédéfinie entre le moment de détection et la fin de vie réelle, afin de permettre un remplacement aisé de la batterie (par exemple deux mois d'utilisation normale). La détermination du seuil peut par exemple comprendre les étapes suivantes :
- un vieillissement de la batterie jusqu'à la fin de vie réelle (l'instant de fin de vie réelle de la batterie est représentée par *t_{B}* sur la figure 3, cela correspond à l'instant où la batterie devient totalement inutilisable) ;
- une détermination d'un nombre de segments équivalent à une durée de deux mois (sur la figure 3, l'instant *t_{A}* précède l'instant *t_{B}* de deux mois, le nombre de segments équivalent à deux mois correspond au nombre de segments compris dans la durée (*t_{B} - t_{A}*)) ; et
- une détermination de la valeur du seuil en partant de la fin de vie réelle et en se décalant du nombre de segments équivalents à deux mois (la valeur du seuil à utiliser correspond à la valeur prise par la courbe 30 à l'instant *t_{A}*).

Tel qu'illustré sur la figure 1, la méthode 100 selon l'invention peut également comporter une étape optionnelle d'estimation 130 de la fiabilité statistique du segment considéré, et un filtrage du segment si celui-ci est jugé non fiable (le segment et les mesures associées sont alors ignorés, c'est-à-dire qu'ils ne sont pas pris en compte dans l'évaluation 160 du critère de détection de fin de vie).

Ce filtrage d'un segment jugé non fiable permet d'éviter de prendre en compte des valeurs aberrantes dans l'analyse de l'état de santé de la batterie.

La fiabilité statistique d'un segment est estimée en fonction des composantes intrinsèques du signal de courant de floating obtenues pour le segment.

Selon un premier exemple, la fiabilité statistique du segment est estimée en fonction d'une entropie calculée pour une somme des composantes intrinsèques du signal de courant de floating (par exemple pour la somme de l'ensemble des composantes intrinsèques obtenues par la décomposition EMD, ou pour la somme d'un nombre maximum prédéfini des premières composantes intrinsèques obtenues par la décomposition EMD). Différentes méthodes de calcul d'entropie peuvent être envisagés, comme par exemple un calcul d'entropie de Shannon, ou un calcul d'entropie de Kolmogorov. Par exemple, les segments pour lesquelles l'entropie calculée est trop faible (inférieure à un seuil d'entropie prédéterminé) sont filtrés. Un seuil d'entropie de Shannon compris entre 0.25 et 0.5 peut notamment être envisagé.

Selon un deuxième exemple, la fiabilité statistique d'un segment est estimée en comparant l'énergie intrinsèque totale calculée pour le segment avec un seuil d'énergie prédéterminé. Par exemple, les segments qui présentent une valeur d'énergie intrinsèque totale aberrante (supérieure au seuil d'énergie) sont filtrés.

Selon encore un autre exemple, la fiabilité statistique d'un segment est estimée en comparant l'énergie intrinsèque totale calculée pour le segment avec les énergies intrinsèques totales calculées pour tout ou partie des segments précédents (par exemple les énergies intrinsèques totales peuvent être comparées entre elles, ou bien l'énergie intrinsèque totale du segment courant peut être comparée à une valeur moyenne des énergies intrinsèques totales de segments précédents). Différents tests statistiques peuvent être envisagés dans ce but (test de Pierce, test de Pierson, etc.).

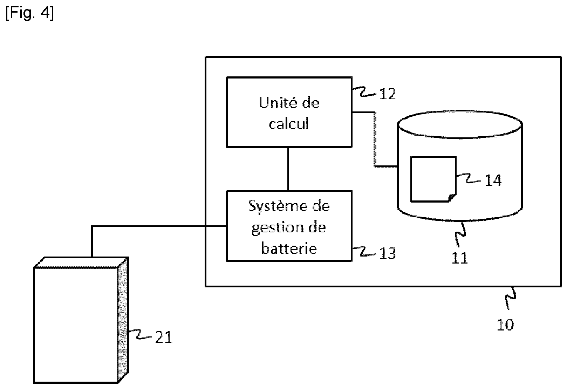

La figure 4 représente schématiquement un dispositif 10 pour la prédiction de la fin de vie d'une batterie 21 au plomb. Le dispositif 10 comporte notamment une mémoire 11, un système de gestion 13 de batterie et une unité de calcul 12 connectée à la mémoire 11 et au système de gestion 13 de batterie.

Le système de gestion 13 de batterie est configuré pour fournir des mesures de courant effectuées au niveau de la batterie 21 pendant au moins un segment une phase CV de la batterie.

L'unité de calcul 12 est configurée pour mettre en œuvre la méthode 100 selon l'un quelconque des modes de mise en œuvre décrits ci-avant.

## Revendications

1. Méthode (100) pour la prédiction de la fin de vie d'une batterie (21) au plomb, la méthode (100) comportant, pour chaque segment d'une pluralité de segments d'une phase de « tension constante », ou phase CV, d'un cycle de charge de la batterie :
- une collecte (110) d'une pluralité de mesures de courant circulant dans la batterie (21) pendant ledit segment, ladite pluralité de mesures formant un signal de « courant de floating » pour ledit segment,
**caractérisée en ce que** la méthode comporte en outre :
- une décomposition en modes empiriques (120) du signal de courant de floating afin d'en obtenir une représentation sous la forme d'une somme d'un signal résiduel et d'une ou plusieurs composantes intrinsèques,
- un calcul (140) d'une énergie intrinsèque pour chaque composante intrinsèque,
- un calcul (150) d'une énergie intrinsèque totale en fonction des énergies intrinsèques des différentes composantes intrinsèques,
- une évaluation (160) d'un critère de détection de fin vie pour la batterie (21) en fonction de l'énergie intrinsèque totale.

2. Méthode (100) selon la revendication 1 dans laquelle l'évaluation (160) du critère de détection de fin de vie comprend une comparaison de l'énergie intrinsèque totale du segment avec un seuil d'énergie prédéterminé.

3. Méthode (100) selon la revendication 2 dans laquelle l'évaluation (160) du critère de détection de fin de vie comprend une vérification si l'énergie intrinsèque totale est inférieure ou égale au seuil d'énergie pour un nombre prédéterminé de segments consécutifs.

4. Méthode (100) selon l'une quelconques des revendications 1 à 3 dans laquelle l'évaluation (160) du critère de détection de fin de vie comprend :
- un calcul d'une énergie intrinsèque totale moyenne pour le segment et des segments précédents,
- une comparaison d'une distance entre l'énergie intrinsèque totale du segment et l'énergie intrinsèque totale moyenne avec un seuil de distance prédéterminé.

5. Méthode (100) selon la revendication 4 dans laquelle l'énergie intrinsèque totale moyenne est calculée en prenant en compte l'énergie intrinsèque totale du segment et les énergies intrinsèques totales de tous les segments précédents.

6. Méthode (100) selon la revendication 4 dans laquelle l'énergie intrinsèque totale moyenne est calculée en prenant en compte l'énergie intrinsèque totale du segment et les énergies intrinsèques totales d'un sous-ensemble des segments précédents.

7. Méthode (100) selon l'une quelconque des revendications 1 à 6, comportant en outre, pour chaque segment de la pluralité de segments, une estimation (130) d'une fiabilité statistique du segment, en fonction des composantes intrinsèques du signal de courant de floating du segment, et un filtrage du segment si celui-ci est jugé non fiable.

8. Méthode (100) selon la revendication 7, dans laquelle la fiabilité statistique du segment est estimée en fonction d'une entropie calculée pour une somme des composantes intrinsèques du signal de courant de floating du segment.

9. Méthode (100) selon l'une quelconque des revendications 7 à 8 dans laquelle, pour chaque segment de la pluralité de segments, la fiabilité statistique d'un segment est estimée en comparant l'énergie intrinsèque totale du segment avec un seuil de fiabilité prédéterminé, ou avec les énergies intrinsèques totales calculées pour tout ou partie des segments précédents.

10. Méthode (100) selon l'une quelconque des revendications 1 à 9, dans laquelle la batterie (21) fait partie d'un système d'alimentation sans interruption pour un serveur de données.

11. Méthode (100) selon l'une quelconque des revendications 1 à 9, dans laquelle la batterie (21) est une batterie d'un véhicule automobile.

12. Dispositif (10) pour la prédiction de la fin de vie d'une batterie (21) au plomb, ledit dispositif (10) comportant :
- un système de gestion (13) de batterie configuré pour fournir des mesures de courant circulant dans la batterie (21) pendant une phase « tension constante », ou phase CV, d'un cycle de charge de la batterie (21),
- une unité de calcul (12) connectée au système de gestion (13) de batterie, ladite unité de calcul (12) étant configurée pour mettre en œuvre une méthode selon l'une quelconque des revendications 1 à 11.

## Patentansprüche

1. Verfahren (100) zur Vorhersage des Lebensendes einer Bleibatterie (21), wobei das Verfahren (100) für jedes Segment einer Vielzahl von Segmenten einer "Konstantspannungsphase", oder CV-Phase, einen Ladezyklus der Batterie umfasst:
- Sammeln (110) einer Vielzahl von Messungen des in der Batterie (21) während des Segments fließenden Stroms, wobei die Vielzahl von Messungen ein "Floating-Strom"-Signal für das Segment bildet,
**dadurch gekennzeichnet, dass** das Verfahren ferner Folgendes umfasst:
- empirisches Aufschlüsseln (120) des Floating-Strom-Signals, um eine Darstellung in Form einer Summe aus einem Restsignal und einer oder mehreren intrinsischen Komponenten zu erhalten,
- Berechnen (140) einer intrinsischen Energie für jede intrinsische Komponente,
- Berechnen (150) einer gesamten intrinsischen Energie in Abhängigkeit von den intrinsischen Energien der verschiedenen intrinsischen Komponenten,
- Bewerten (160) eines Lebensende-Erkennungskriteriums für die Batterie (21) in Abhängigkeit von der gesamten intrinsischen Energie.

2. Verfahren (100) nach Anspruch 1, wobei das Bewerten (160) des Lebensende-Erkennungskriteriums das Vergleichen der gesamten intrinsischen Energie des Segments mit einem vorbestimmten Energieschwellenwert einschließt.

3. Verfahren (100) nach Anspruch 2, wobei das Bewerten (160) des Lebensende-Erkennungskriteriums das Überprüfen, ob die gesamte intrinsische Energie für eine vorbestimmte Anzahl aufeinanderfolgender Segmente kleiner oder gleich dem Energieschwellenwert ist, einschließt.

4. Verfahren (100) nach einem der Ansprüche 1 bis 3, wobei das Bewerten (160) des Lebensende-Erkennungskriteriums Folgendes einschließt:
- Berechnen einer durchschnittlichen gesamten intrinsischen Energie für das Segment und die vorhergehenden Segmente,
- Vergleichen eines Abstands zwischen der gesamten intrinsischen Energie des Segments und der durchschnittlichen gesamten intrinsischen Energie mit einer vorbestimmten Abstandsschwelle.

5. Verfahren (100) nach Anspruch 4, wobei die durchschnittliche gesamte intrinsische Energie unter Berücksichtigung der gesamten intrinsischen Energie des Segments und der gesamten intrinsischen Energien aller vorhergehenden Segmente berechnet wird.

6. Verfahren (100) nach Anspruch 4, wobei die durchschnittliche gesamte intrinsische Energie unter Berücksichtigung der gesamten intrinsischen Energie des Segments und der gesamten intrinsischen Energien einer Untergruppe der vorhergehenden Segmente berechnet wird.

7. Verfahren (100) nach einem der Ansprüche 1 bis 6, das ferner für jedes Segment der Vielzahl von Segmenten ein Schätzen (130) einer statistischen Zuverlässigkeit des Segments in Abhängigkeit von den intrinsischen Komponenten des Floating-Strom-Signals des Segments und ein Filtern des Segments umfasst, wenn dieses als unzuverlässig erachtet wird.

8. Verfahren (100) nach Anspruch 7, wobei die statistische Zuverlässigkeit des Segments in Abhängigkeit von einer berechneten Entropie für eine Summe der intrinsischen Komponenten des Floating-Strom-Signals des Segments geschätzt wird.

9. Verfahren (100) nach einem der Ansprüche 7 bis 8, wobei für jedes Segment der Vielzahl von Segmenten die statistische Zuverlässigkeit eines Segments durch Vergleich der gesamten intrinsischen Energie des Segments mit einer vorbestimmten Zuverlässigkeitsschwelle oder mit den berechneten gesamten intrinsischen Energien für alle oder einen Teil der vorhergehenden Segmente geschätzt wird.

10. Verfahren (100) nach einem der Ansprüche 1 bis 9, wobei die Batterie (21) Teil eines unterbrechungsfreien Stromversorgungssystems für einen Datenserver ist.

11. Verfahren (100) nach einem der Ansprüche 1 bis 9, wobei die Batterie (21) eine Batterie für ein Kraftfahrzeug ist.

12. Vorrichtung (10) zur Vorhersage des Lebensendes einer Bleibatterie (21), wobei die Vorrichtung (10) Folgendes umfasst:
- ein Batteriemanagementsystem (13), das so konfiguriert ist, dass es Messungen des in der Batterie (21) fließenden Stroms während einer "Konstantspannungs"-Phase, oder CV-Phase, eines Ladezyklus der Batterie (21) liefert,
- eine Recheneinheit (12), die mit dem Batteriemanagementsystem (13) verbunden ist, wobei die Recheneinheit (12) so konfiguriert ist, dass sie ein Verfahren nach einem der Ansprüche 1 bis 11 durchführt.

## Claims

1. Method (100) for predicting the end of life of a lead-acid battery (21), the method (100) comprising, for each segment of a plurality of segments of a "constant voltage" phase, or CV phase, of a charging cycle of the battery:
- collecting (110) a plurality of measurements of current flowing in the battery (21) during said segment, said plurality of measurements forming a "floating current" signal for said segment,
**characterized in that** the method further comprises:
- decomposing into empirical modes (120) the floating current signal in order to obtain therefrom a representation in the form of a sum of a residual signal and of one or more intrinsic component(s),
- calculating (140) an intrinsic energy for each intrinsic component,
- calculating (150) a total intrinsic energy as a function of the intrinsic energies of the different intrinsic components,
- evaluating (160) an end-of-life detection criterion for the battery (21) as a function of the total intrinsic energy.

2. Method (100) according to claim 1, wherein evaluating (160) the end-of-life detection criterion comprises comparing the total intrinsic energy of the segment with a predetermined energy threshold.

3. Method (100) according to claim 2, wherein evaluating (160) the end-of-life detection criterion comprises verifying whether the total intrinsic energy is less than or equal to the energy threshold for a predetermined number of consecutive segments.

4. Method (100) according to any one of claims 1 to 3, wherein evaluating (160) the end-of-life detection criterion comprises:
- calculating an average total intrinsic energy for the segment and the previous segments,
- comparing a distance between the total intrinsic energy of the segment and the average total intrinsic energy with a predetermined distance threshold.

5. Method (100) according to claim 4, wherein the average total intrinsic energy is calculated taking the total intrinsic energy of the segment and the total intrinsic energies of all preceding segments into account.

6. Method (100) according to claim 4, wherein the average total intrinsic energy is calculated taking the total intrinsic energy of the segment and the total intrinsic energies of a subset of the preceding segments into account.

7. Method (100) according to any one of claims 1 to 6, further comprising, for each segment of the plurality of segments, estimating (130) a statistical reliability of the segment, according to the intrinsic components of the floating current signal of the segment, and filtering the segment if the latter is found to be unreliable.

8. Method (100) according to claim 7, wherein the statistical reliability of the segment is estimated according to an entropy calculated for a sum of the intrinsic components of the floating current signal of the segment.

9. Method (100) according to any one of claims 7 to 8 wherein, for each segment of the plurality of segments, the statistical reliability of a segment is estimated by comparing the total intrinsic energy of the segment with a predetermined reliability threshold, or with the total intrinsic energies calculated for all or part of the preceding segments.

10. Method (100) according to any one of claims 1 to 9, wherein the battery (21) is part of an uninterruptible power supply system for a data server.

11. Method (100) according to any one of claims 1 to 9, wherein the battery (21) is a battery of an automobile vehicle.

12. Device (10) for predicting the end of life of a lead-acid battery (21), said device (10) comprising:
- a battery management system (13) configured to provide measurements of current flowing in the battery (21) during a "constant voltage" phase, or CV phase, of a charging cycle of the battery (21),
- a calculation unit (12) connected to the battery management system (13), said calculation unit (12) being configured to implement a method according to any one of claims 1 to 11.
